# EUROPEAN PATENT APPLICATION

(11) **EP 2 103 645 A1**
(43) Date of publication of application: **23.09.2009**
(21) Application number: 09003812.6
(22) Date of filing: 17.03.2009
(51) Int. Cl.: C08J 7/04, H01L 51/50

(54) **Barrier laminate and method for producing same, device and optical component**

(30) Priority: 17.03.2008 JP 2008067540
(71) Applicant: Fujifilm Corporation, Tokyo 106-0031 (JP)
(72) Inventor: Tsukamoto, Naoki, Ashigarakami-gun Kanagawa 258-8577 (JP)
(74) Representative: HOFFMANN EITLE

(57) **Abstract**

In a method for producing a barrier laminate having an organic layer and an inorganic layer on a support, the organic layer is formed by sputtering. The barrier laminate produced by the method has an excellent barrier property.

## Description

### BACKGROUND OF THE INVENTION

### Field of the Invention

The present invention relates to a barrier laminate having at least one organic layer and at least one inorganic layer on a support, and to a method for producing it. The invention also relates to a device and an optical component comprising the barrier laminate.

### Description of the Related Art

Recently, in the field of liquid-crystal display devices and organic EL devices (organic electroluminescent devices), plastic film substrates are being used in place of glass substrates that are heavy and readily cracked or broken. As applicable to a roll-to-roll system, plastic film substrates are advantageous in point of the production efficiency and cost. However, plastic film substrates are problematic in that their water vapor-barrier capability is not good as compared with that of glass substrates. Therefore, when a plastic film substrate having poor water vapor-barrier capability is used in a liquid-crystal display device and an organic EL device, then water vapor may penetrate into the liquid-crystal cell, thereby causing display failures.

Accordingly, for enhancing the barrier capability of a plastic film substrate, widely employed is a technique of forming a barrier inorganic layer on a plastic film support. For example, known are one produced by depositing silicon oxide on a plastic film support in a mode of vapor deposition (e.g., see JP-B 53-12953 (pp. 1-3)), and one produced by depositing aluminum oxide on a plastic film support also in a mode of vapor deposition (e.g., see JP-A 58-217344 (pp. 1-4)). However, since a plastic film support may be scratched or may have dust adhering thereto, it could not have a sufficient barrier property even though an inorganic layer is directly formed on such a plastic film support.

For solving the problem, a plastic film substrate has been developed, as produced by forming an organic layer on a plastic film support and further forming an inorganic layer thereon. As such an organic/inorganic laminate barrier film substrate, proposed are one capable of realizing a water vapor permeability of less than 0.1 g/m²/day (e.g., see JP-A 2003-335880 and JP-A 2003-335820), and one capable of realizing a further lower water vapor permeability (e.g., see JP-A 2005-7741). Those organic/inorganic laminate plastic film substrates may be produced by forming an organic layer on a plastic film support according to a vapor deposition method or a plasma polymerization method, and further forming an inorganic layer thereon according to a sputtering method (e.g., see JP-A 2003-109748).

However, the vapor deposition method and the plasma polymerization method require an indispensable step of subliming an organic material, in which, therefore, the molecular weight of the organic material to be used is limited. In addition, the vapor deposition method has another limitation in that only an organic material that does neither decompose nor carbonize through heating for sublimation can be used therein Accordingly, the vapor deposition method and the plasma polymerization method are problematic in that a desired organic layer could not always be formed on a plastic film support. In addition, the laminate produced according to the method described in JP-A 2003-109748 is not always satisfactory in point of the barrier property, and must be further improved for its use in liquid-crystal display devices and organic EL devices, etc.

Taking the above-mentioned problems in the related art into consideration, the present inventors have made further investigations for the purpose of providing a barrier laminate with an organic/inorganic laminate structure having a better barrier property than before according to a simple method. In addition, the inventors have also made various investigations for the purpose of providing a method capable of forming an organic layer and an inorganic layer continuously in a one-through process in a vacuum condition. Furthermore, the inventors have made additional investigations for the purpose of providing a high-barrier laminate comprising novel materials and providing a device and an optical component excellent in durability, according to such novel production methods.

### SUMMARY OF THE INVENTION

As a result of assiduous investigations for the purpose of attaining the above-mentioned objects, the inventors have found that, when an organic layer is formed on a support according to a specific method and then an inorganic layer is further formed thereon, then the prior-art problems as above can be solved. As a result, the inventors have reached the present invention described below.
[1] A method for producing a barrier laminate having at least one organic layer and at least one inorganic layer on a support, which comprises forming the organic layer by sputtering.
[2] The method for producing a barrier laminate of the above [1], wherein the organic layer is formed with applying a bias current to the support.
[3] The method for producing a barrier laminate of the above [1] or [2], wherein the organic layer comprises a polyether sulfone as the main ingredient thereof.
[4] The method for producing a barrier laminate of any one of the above [1] to [3], wherein the support is a plastic film.
[5] The method for producing a barrier laminate of any one of the above [1] to [3], wherein the support is an organic EL substrate.
[6] The method for producing a barrier laminate of any one of the above [1] to [5], which further comprises forming the inorganic layer by sputtering.
[7] The method for producing a barrier laminate of the above [6], wherein the inorganic layer is a layer comprising aluminum oxide or silicon nitride.
[8] The method for producing a barrier laminate of any one of the above [1] to [5], wherein the inorganic layer is formed by CVD.
[9] The method for producing a barrier laminate of the above [8], wherein the inorganic layer is a layer comprising silicon nitride.
[10] The method for producing a barrier laminate of the above [7], wherein the organic layer and the inorganic layer are formed in the same sputtering apparatus.
[11] The method for producing a barrier laminate of any one of the above [6] to [9], wherein the organic layer and the inorganic layer are formed in order while kept in a vacuum.
[12] A barrier laminate produced according to the method of any one of the above [1] to [11].
[13] A barrier laminate having at least one organic layer and at least one inorganic layer on a support, wherein the organic layer is a layer formed by using a target of an organic material having a molecular weight of at least 2000 as a main ingredient, or the organic layer is a layer comprising an organic material having a molecular weight of at least 2000 as a main ingredient, and the barrier laminate has a water vapor permeability of less than 0.1 g/m²/day.
[14] A barrier laminate having at least one organic layer and at least one inorganic layer on a support, wherein the organic layer is a layer comprising a polyethylene naphthalate or a polyether sulfone as a main ingredient, and the barrier laminate has a water vapor permeability of less than 0.1 g/m²/day.
[15] A device comprising the barrier laminate of any one of the above [12] to [14].
[16] A device comprising, as a sealant film, the barrier laminate of any one of the above [12] to [14].
[17] The device of the above [15] or [16], which is an organic EL device.
[18] An optical component comprising the barrier laminate of any one of the above [12] to [14].

According to the production method of the invention, there is provided a barrier laminate having an organic/inorganic laminate structure, using various organic materials with no limitation in point of the molecular weight thereof. In addition, according to the production method of the invention, an organic layer and an inorganic layer can be produced continuously in a one-through vacuum condition. Further, the barrier laminate produced according to the production method of the invention has a better barrier capability than those produced according to conventional methods, and the device and the optical component comprising the laminate have excellent durability.

### BRIEF DESCRIPTION OF THE DRAWINGS

Fig. 1 is an outline view of a sputtering apparatus usable in the production method of the invention.
Fig. 2 is an outline view of another sputtering apparatus also usable in the production method of the invention.

### BEST MODE FOR CARRYING OUT THE INVENTION

The contents of the invention are described in detail hereinunder. The description of the constitutive elements of the invention given hereinunder is for some typical embodiments of the invention, to which, however, the invention should not be limited. In this description, the numerical range expressed by the wording "a number to another number" means the range that falls between the former number indicating the lowermost limit of the range and the latter number indicating the uppermost limit thereof.

### <Support>

The support is the base of the barrier laminate of the invention, on which at least one organic layer and at least one inorganic layer are formed.

In the barrier laminate of the invention, the support is preferably a plastic film. Not specifically defined in point of the material and the thickness thereof, the plastic film usable in the invention may be any one capable of supporting the laminate of the organic layer and the inorganic layer formed on its surface; and it may be suitably selected depending on the use and the object thereof. Concretely, the plastic film includes thermoplastic resins such as polyester resin, methacryl resin, methacrylic acid-maleic anhydride copolymer, polystyrene resin, transparent fluororesin, polyimide resin, fluoropolyimide resin, polyamide resin, polyamidimide resin, polyetherimide resin, cellulose acylate resin, polyurethane resin, polyether ether ketone resin, polycarbonate resin, alicyclic polyolefin resin, polyarylate resin, polyether sulfone resin, polysulfone resin, cycloolefin copolymer, fluorene ring-modified polycarbonate resin, alicyclic-modified polycarbonate resin, fluorene ring-modified polyester resin, acryloyl compound, etc.

When the barrier laminate of the invention must be resistant to heat, then the support must also be resistant to heat. For example, in case where the barrier laminate of the invention is used as a substrate of a device such as an organic EL device to be mentioned hereinunder, it is desirable that the support is formed of a heat-resistant material. Concretely, the support is preferably formed of a heat-resistant transparent material having a glass transition temperature (Tg) of not lower than 100°C and/or a linear thermal expansion coefficient of at most 40 ppm/°C. For example, the material is a thermoplastic resin preferably having, as the constitutive simple polymer thereof, Tg of from 70°C to 350°C, more preferably not lower than 120°C. The thermoplastic resin of the type includes, for example, polyethylene naphthalate (PEN: 120°C), polycarbonate (PC: 140°C), alicyclic polyolefin (e.g., Nippon Zeon's Zeonoa 1600: 160°C), polyarylate (PAr: 210°C), polyether sulfone (PES: 220°C), polysulfone (PSF: 190°C), cycloolefin copolymer (COC, compound described in JP-A 2001-150584: 162°C), polyimide (e.g., Mitsubishi Gas Chemical's Neoprim: 260°C), fluorene ring-modified polycarbonate (BCF-PC, compound described in JP-A 2000-227603: 225°C), alicyclic-modified polycarbonate (IP-PC, compound described in JP-A 2000-227603: 205°C), acryloyl compound (compound described in JP-A 2002-80616: 300°C or more) (the parenthesized data are Tg). In particular, for high transparency, use of alicyclic polyolefin and the like is preferred. Tg and the linear expansion coefficient may be controlled by the additives to the material.

As the support of the barrier laminate of the invention, also usable is a thermosetting resin. The thermosetting resin includes an epoxy resin and a radiation-curable resin. The epoxy resin includes polyphenol-type, bisphenol-type, halogenobisphenol-type and novolak-type resins. Any known curing agent may be used for curing the epoxy resin. For example, the usable curing agent includes amines, polyaminoamides, acids, acid anhydrides, imidazoles, mercaptans, phenol resins, etc. Above all, from the viewpoint of the solvent resistance, the optical properties and the thermal properties of the cured resins, preferred are acid anhydrides or acid anhydride structure-having polymers or aliphatic amines; and more preferred are acid anhydrides and acid anhydride structure-having polymers. Also preferably, a suitable amount of a curing catalyst of a known tertiary amines, imidazoles and the like may be added to the resin.

In case where the barrier laminate of the invention is combined with a polarizer in its use, it is desirable that the barrier layer side (on which a laminate containing at least one inorganic layer and at least one organic layer is formed) of the barrier laminate faces the inside of the cell, and is disposed in the innermost site (adjacent tb the device). In this case, the barrier laminate is disposed more inside the cell than the polarizer, and therefore the retardation of the barrier laminate is an important factor. In case where the barrier laminate is used in the manner as above, preferred is any of the following embodiments: The barrier laminate comprising a support having a retardation of at most 10 nm is laminated with a circular polarizer (1/4 wavelength plate + (1/2 wavelength plate) + linear polarizer) ; or the barrier laminate comprising a support having a retardation of from 100 nm to 180 nm, which is usable as a 1/4 wavelength plate, is combined with a linear polarizer.

The support having a retardation of at most 10 nm includes cellulose triacetate (FUJIFILM's Fujitac), polycarbonate (Teijin Chemical's Pureace, Kaneka's Elmec), cycloolefin copolymer (JSR's Arton, Nippon Zeon's Zeonoa), cycloolefin copolymer (Mitsui Chemical's Apel (pellets), Polyplastic's Topas (pellets)), polyarylate (Unitika's U100 (pellets)), transparent polyimide (Mitsubishi Gas Chemical's Neoprim), etc. As the 1/4 wavelength plate, usable is a film produced by suitably stretching the above-mentioned film to have a desired retardation.

In case where the barrier laminate of the invention is used in a device such as an organic EL device, its support is preferably transparent. In such applications that require transparency, the light transmittance of the support is preferably at least 80%, more preferably at least 85%, even more preferably at least 90%. The light transmittance may be measured according to the method described in JIS-K7105. Concretely, using an integrating sphere-type light transmittance meter, a whole light transmittance and a quantity of scattered light are measured, and the diffusive transmittance is subtracted from the whole transmittance to obtain the intended light transmittance of the sample.

Even when the barrier laminate of the invention is used in displays, it does not always require transparency in a case where it is not disposed on the viewers' side. Accordingly in such a case, a nontransparent material may be used for the support. The nontransparent material includes, for example, polyimide, polyacrylonitrile, known liquid-crystal polymer.

Not specifically defined, the thickness of the support for use in the barrier laminate of the invention may be suitably selected depending on its use. In case where the above-mentioned plastic film or the like is used as the support, its thickness may be typically from 1 to 800 µm, preferably from 10 to 200 µm. The support may have a functional layer such as a transparent conductive layer, a primer layer, etc. Furthermore, the support may preferably have the layer described in [0036] to [0038] of JP-A 2006-289627.

In the invention, a device such as an organic EL device or an optical component may be selected as the support. In particular, when a device or an optical component that requires sealing is selected as the support and when at least one organic layer and at least one inorganic layer are formed thereon according to the production method of the invention, then the device or the optical component may be effectively sealed up. The details of the device and the optical component are described below.

### <Organic Layer>

The barrier laminate of the invention is **characterized in that** the organic layer therein is formed according to a sputtering method.

The sputtering method is as follows: While an inert gas is introduced into a vacuum chamber, an auto-bias is applied to the target through direct-current voltage or high frequency application thereto, whereby the ion generated by plasma formation from the inert gas is made to collide against the target, and the target substance thus sputtered out trough the collision is stuck to the support. In the invention, an auto-bias by high frequency is applied to the target that comprises an organic material as the main ingredient, and an organic layer is thereby formed on a support.

According to the production method of the invention, a wide-range organic material may be used as the target and an organic layer may be formed with it. Specifically, any solid organic material may be used as the target with no limitation. Its advantage is that an organic material having a large molecular weight can be used as the target. For example, an organic material having a molecular weight of 2000 or more can be used as the target; and within a larger molecular weight region, an organic material having a molecular weight of 5000 or more can be used as the garget; and within a still larger molecular weight region , an organic material having a molecular weight of 10000 or more can be used as the target. The organic materials having such a large molecular weight could not be used for organic layer formation in a conventional vapor deposition method or plasma polymerization method. Therefore, according to the production method of the invention, the latitude in selecting the usable organic material is broadened, and another advantage of the production method is that any organic material having a desired function can be freely selected and used therein. This brings about still another advantage in that the material planning is easy and the industrial applicability of the invention is enhanced.

The organic layer to be formed in the invention is generally a layer formed of a polymer. Concretely, it is preferably a layer of a thermoplastic resin such as polyester resin, methacryl resin, methacrylic acid-maleic anhydride copolymer, polystyrene resin, transparent fluororesin, polyimide resin, fluoropolyimide resin, polyamide resin, polyamidimide resin, polyetherimide resin, cellulose acylate resin, polyurethane resin, polyether ether ketone resin, polycarbonate resin, alicyclic polyolefin resin, polyarylate resin, polyether sulfone resin, polysulfone resin, fluorene ring-modified polycarbonate resin, alicyclic-modified polycarbonate resin, fluorene ring-modified polyester resin, acryloyl compound; or silicon containing polymer such as polysiloxane.

In the invention, preferred examples of the organic material mainly used for the organic layer are polyethylene naphthalate (PEN), polymethyl methacrylate (PMMA), polyester, cycloolefin polymer (e.g., Zeonoa (trade name)), and polyether sulfone (PES). Of those, more preferred are polyester, cycloolefin polymer, and polyether sulfone; and even more preferred are cycloolefin polymer and polyether sulfone; still more preferred is polyether sulfone. In this, the organic material mainly used in the organic layer means that the organic material is in the organic layer in an amount of at least 80% by mass, more preferably at least 90% by mass, even more preferably at least 95% by mass.

In sputtering to form the organic layer, the inert gas is preferably an element of the Group 18, such as helium gas, neon gas, argon gas, krypton gas or xenon gas, more preferably argon gas in view of the degree of sputtering and the cost. A minor amount of oxygen gas or nitrogen gas may be added to the inert gas for reactive sputtering.

In forming the organic layer, usable is a sputtering apparatus in which an organic material is used as the target. A sputtering apparatus exclusive for organic materials may be used. When the coated support is transferred into another vacuum chamber in a continuous vacuum line, then both the organic layer and the inorganic layer may be continuously formed all in vacuum according to a sputtering method or a CVD method. A sputtering apparatus where both the organic layer and the inorganic layer may be formed by sputtering may also be used herein.

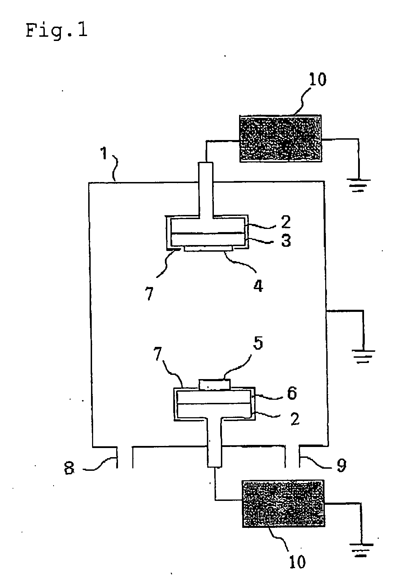

The sputtering method for forming the organic layer is concretely described with reference to Fig. 1 that illustrates an example of a sputtering apparatus.

The sputtering apparatus of Fig. 1 has a high-frequency electrode 2 disposed in an earthed vacuum chamber 1. An inert gas is introduced into the vacuum chamber 1 through an inert gas inlet port 8, and discharged out through the exhaust port 9. To the high-frequency electrode 2, an RF power is given from an RF power source and a matching box 10.

In forming the organic layer, a support 5 for the barrier laminate of the invention is fixed on a holder 6. In this step, the support 5 may be merely mounted on the holder 6 or may be fixed thereto with an adhesive.

An organic material 4 to be a sputtering target is stuck to a backing plate 3; and this is attached to the high-frequency electrode 2 as in Fig. 1. Before the organic material is stuck to the backing plate, the organic material may be dried, if desired. For example, the organic material may be exposed to dry gas, or may be heated in vacuum, whereby the organic material may be previously dried. The organic material to be stuck to the backing plate may have any form that may be sputtered. In general, it is stuck to the plate as a film. The method of sticking the organic material to the plate is not specifically defined. For example, it may be stuck to the backing plate with an epoxy-type or silicone resin adhesive.

After the support 5 and the organic material 4 are thus installed, the vacuum chamber 1 is degassed to be in a vacuum. In degassing it, suitably used is a rotary pump, a turbo pump or the like. If desired, the vacuum chamber may be heated. In the invention, the pressure in sputtering to form the organic layer is preferably from 0.01 to 100 Pa, more preferably from 0.1 to 10 Pa, even more preferably from 1 to 10 Pa. While an inert gas is introduced into the vacuum chamber 1 through the inert gas inlet port 8, and discharged out through the exhaust port 9, an RF power is given to the high-frequency electrode 2 to generate a plasma for sputtering. In this step, a bias (substrate bias) is preferably given to the support in forming the organic layer, whereby the barrier property of the formed layer may be further enhanced. The bias may be generally from 25 to -200 V, preferably from 25 to -100 V, more preferably from 25 to -50 V.

The plasma generation power source and the bias power source are not specifically defined, for which, therefore, usable are an RF power source (1 MHz or more), an MF power source (1 MHz or less) and others for use for insulator target sputtering. The plasma generation power source and the bias application power source for the support may be the same or different ones. In case where power sources of the same frequency are used, the phase shall differ between the two.

During sputtering, the support temperature may be generally from -40 to 100°C, preferably from -20 to 50°C, even more preferably from 0 to 25°C. Before starting the sputtering, cooling water may be given between the high-frequency electrode 2 and the backing plate 3 to cool them. During sputtering, preferably, the support is rotated and moved so as to make the formed layer have a uniform thickness.

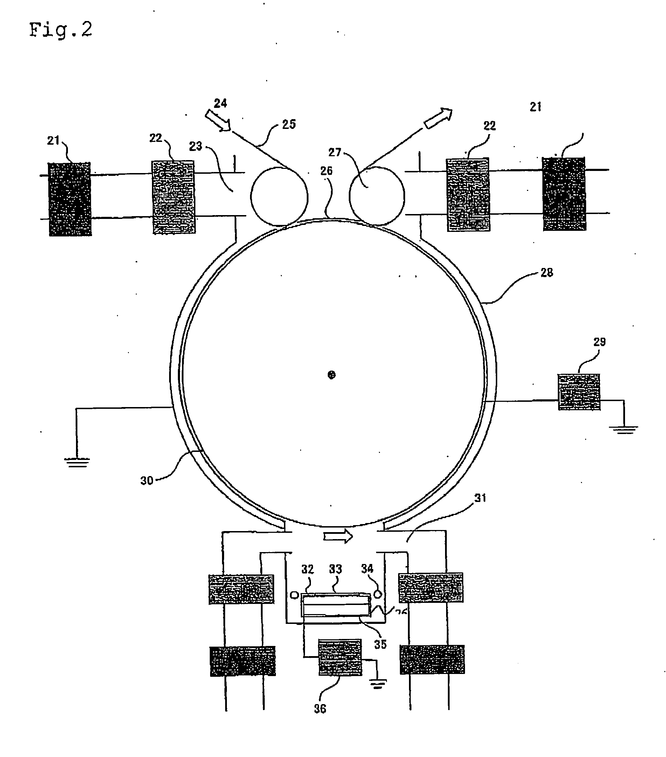

For forming the organic layer by sputtering, also preferably usable is a sputtering apparatus of Fig. 2.

In the sputtering apparatus of Fig. 2, an organic layer is formed while a beltlike support film is conveyed, and it may be continuously formed according to a roll-to-roll system. The support 25 is conveyed on the drum 30 in the chamber 28 in the direction of the arrow 24 via the pass roll 27. An RF power source for the drum and a matching box 29 are connected to the drum 30. An organic material target 33 is stuck to the backing plate 32 attached to the high-frequency electrode 35; and an RF power source and a matching box 36 are connected to the high-frequency electrode 35. An inert gas is introduced through the inert gas inlet port 34 and discharged through the exhaust port 31. At the exhaust port 31, installed are a rotary pump 21 and a turbo pump 22 by which the chamber can be degassed.

The thickness of the organic layer to be formed according to the sputtering method is not specifically defined. Preferably, it may be from 50 nm to 2000 nm, more preferably from 200 nm to 1500 nm. When the thickness is at least 50 nm, then it is favorable since the layer defects may be reduced and the barrier property of the layer may be better; and when the thickness is at most 1500 nm, it is also favorable since the film is hardly cracked by external force given thereto and its barrier property is hardly lowered. The thickness of the organic layer may be controlled by controlling the power and the time for layer formation in sputtering.

In the invention, two or more organic layers may be formed as laminated. In this case, the constitutive layers may have the same composition or may differ in point of their composition. In case where two or more organic layers are laminated, at least one of them may be formed by sputtering and the others may be formed in any other different method. Preferably, all the organic layers of the barrier laminate of the invention are formed by sputtering.

Formation of the organic layer by sputtering according to the production method of the invention enables continuous one-through formation of inorganic layer in the same vacuum condition. Specifically, the formation of organic layer and inorganic layer may be attained continuously in order while the vacuum condition is kept as such all the time during the formation.

The organic layer formed by sputtering according to the production method of the invention may stiff and tough. Not adhering to any theory, the stiffness and toughness of the organic layer may be owing to crosslinking of the organic layer by radical generation through plasma.

Further, when the organic layer is formed on the support through sputtering according to the invention, the adhesiveness between the organic layer and the support may be enhanced. The enhanced adhesiveness between the organic layer and the support has another advantage in that the layer delamination to be caused by internal stress of inorganic layer may be prevented and the durability of the coated support may be enhanced.

### <Inorganic Layer>

The inorganic layer is generally a thin film layer of a metal compound. For forming the inorganic layer, employable is any method capable of forming the intended thin film layer. For example, employable are physical vapor deposition methods (PVD) such as vapor evaporation method, sputtering method and ion plating method; various chemical vapor deposition methods (CVD); and liquid-phase growth methods such as plating method and sol-gel method; etc. From the viewpoint that the organic layer and the inorganic layer can be formed continuously in one-through vacuum condition, the inorganic layer is preferably formed by sputtering. When the inorganic layer is formed by sputtering, the apparatus where the organic layer is formed may be used as such merely by changing the target, and therefore, the total production apparatus may be down-sized into a compact one, and the production efficiency may be increased.

The ingredients to constitute the inorganic layer are not specifically defined, for which, for example, usable are oxides, nitrides, oxinitrides, carbides and oxicarbides of at least one metal selected from Si, Al, In, Sn, Zn, Ti, Cu, Ce, Ta and the like. Of those, preferred are oxides, nitrides or oxinitrides of a metal selected from Si, Al, In, Sn, Zn and Ti; and more preferred are metal oxides, nitrides or oxinitrides of Si or Al. These may contain any other element as a secondary ingredient.

The thickness of the inorganic layer is not specifically defined. In general, for example, the thickness of one inorganic layer may be from 5 to 300 nm, preferably from 20 to 200 nm, more preferably from 30 to 90 nm.

In the invention, an organic layer may be formed on an inorganic layer, and an inorganic layer may be further formed on the organic layer. Further, alternate lamination of an organic layer and an inorganic layer may be repeated to form a plurality of inorganic layers. In this case, the inorganic layers may have the same composition or may differ in point of the composition thereof. In case where two or more inorganic layers are formed and when an organic layer is formed on each inorganic layer, the production method of the invention may be applied to the case. In the barrier laminate of the invention, the interface between the inorganic layer and the organic layer may be indefinite and a layer of which the composition changes continuously in the thickness direction thereof may exist between the inorganic layer and the organic layer, as in US 2004/46497.

### <Barrier Laminate>

### (Basic Constitution)

The barrier laminate of the invention may have at least one organic layer and at least one inorganic layer on a support, and the other constitution thereof is not specifically defined. In this, it is desirable that an organic layer is first formed on the support and an inorganic layer is then formed on the organic layer. The number of the organic layers and the inorganic layers, if any, is not specifically defined. Preferably, the barrier laminate of the invention has from 2 to 30, more-preferably from 3 to 20 organic layers and inorganic layers. The organic layer and the inorganic layer may be formed on one face or both faces of the support. The organic layer and the inorganic layer may be formed on one face of the support, and any other organic layer and/or inorganic layer not satisfying the requirements of the invention may be formed on the other face thereof. This embodiment is also within the scope of the invention.

In addition to the organic layer and the inorganic layer, any other layer may be formed on the support of the barrier laminate of the invention. The other layer may be a functional layer. The functional layer is described in detail in JP-A 2006-289627, paragraphs [0036] to [0038]. Examples of the additional functional layer are an electroconductive layer, a matting amget layer, a protective layer, a solvent-resistant layer, an antistatic layer, a planarizing layer, an adhesiveness-enhancing layer, a light-shielding layer, an antireflection layer, a hard coat layer, a stress relaxation layer, an antifogging layer, an antisoiling layer, a printable layer, an easy adhesive layer, etc. The functional layer may be formed on a barrier layer that comprises at least one organic layer and at least one inorganic layer, or between the barrier layer and the support, or on the other face of the support not coated with an organic layer and an inorganic layer. (Property of Barrier Laminate)

The barrier laminate of the invention is characterized by having a low water vapor permeability. The water vapor permeability of the barrier laminate of the invention is, as measured in an environment at 40°C and a relative humidity of 90%, generally at most 0.01 g/m²/day per one inorganic layer, preferably at most 0.005 g/m²/day, more preferably at most 0. 003 g/m²/day, even more preferably at most 0.001 g/m²/day. When the barrier laminate is used as a sealing material for an organic EL device, the light-emitting surface condition of the device is good with no failures.

### (Use of Barrier Laminate)

The barrier laminate of the invention can be used as a substrate for articles that require a gas-barrier property. For example, it is useful as a substrate for devices and optical components. In addition, the barrier laminate of the invention may also be used for sealing devices or optical components that require a gas-barrier property. These are described in detail hereinunder.

### <Device>

The barrier laminate of the invention is favorably used for devices of which the performance may readily be deteriorated by chemical ingredients in air (e.g., oxygen, water, nitrogen oxides, sulfur oxides, ozone). Examples of the devices are electronic devices such as organic EL devices, liquid-crystal display devices, thin-film transistors, touch panels, electronic papers, solar cells, etc. Of those, preferred are organic EL devices.

The barrier laminate of the invention may also be used for film sealing of devices. Specifically, at least one organic layer and at least one inorganic layer may be formed on the surface of a device that serves as a support, as described in the above, whereby the device can be sealed with the laminate of the thus-formed layers.

Before the organic layer and the inorganic layer are formed, the device may be covered with a protective layer. An adhesive layer may be formed on the protective layer, and then an organic layer and an inorganic layer may be formed thereon. Not specifically defined, the adhesive may be a thermosetting epoxy resin or a photocurable acrylate resin.

### (Organic EL Device)

Examples of an organic EL device with a barrier laminate are described in detail in JP-A 2007-30387.

### (Liquid-Crystal Display Device)

A reflection-type liquid-crystal display device has a constitution of a lower substrate, a reflection electrode, a lower alignment film, a liquid-crystal layer, an upper alignment film, a transparent electrode, an upper substrate, a λ/4 plate and a polarizing film, formed in that order from the bottom. In this, the barrier laminate of the invention may be used as the transparent electrode substrate and the upper substrate. In color displays, it is desirable that a color filter layer is additionally provided between the reflection electrode and the lower alignment film, or between the upper alignment film and the transparent electrode. A transmission-type liquid-crystal display device has a constitution of a backlight, a polarizer, a λ/4 plate, a lower transparent electrode, a lower alignment film, a liquid-crystal layer, an upper alignment film, an upper transparent electrode, an upper substrate, a λ/4 plate and a polarizing film, formed in that order from the bottom. In this, the gas-barrier film of the invention may be used as the upper transparent electrode and the upper substrate. In color displays, it is desirable that a color filter layer is additionally provided between the lower transparent electrode and the lower alignment film, or between the upper alignment film and the transparent electrode. Not specifically defined, the type of the liquid-crystal cell is preferably a TN (twisted nematic) type, an STN (super-twisted nematic) type, a HAN. (hybrid aligned nematic) type, a VA (vertically alignment) type, an ECB (electrically controlled birefringence) type, an OCB (optically compensated bend) type, a CPA (continuous pinwheel alignment) type, or an IPS (in-plane switching) type.

### (Others)

Other applications of the invention are thin-film transistors as in JP-T 10-512104, touch panels as in JP-A 5-127822, 2002-48913, electronic papers as in JP-A 2000-98326, and solar cells as in Japanese Patent Application No. 7-160334.

### <Optical Component>

An example of the optical component that comprises the barrier laminate of the invention is a circular polarizer. (Circular Polarizer)

Laminating a barrier laminate of the invention with a λ/4 plate and a polarizer gives a circular polarizer. In this case, the components are so laminated that the slow axis of the λ/4 plate could cross the absorption axis of the polarizer at an angle of 45°. The polarizer is preferably stretched in the direction of 45° from the machine direction (MD) thereof; and for example, those described in JP-A 2002-86554 are favorably used.

### EXAMPLES

The invention is described more concretely with reference to the following Examples. In the following Examples, the material used, its amount and the ratio, the details of the treatment and the treatment process may be suitably modified or changed. Accordingly, the invention should not be limitatively interpreted by the Examples mentioned below.

### [Example 1]

Production and Evaluation of Barrier Laminate by Sputtering:

### (Production of Sample A-1)

In an earthed vacuum chamber, Ar was used as a discharge gas, a polyethylene naphthalate film (Teijin-DuPont's Teonex Q65FA - hereinafter referred to as PEN film) was used as a support, and Al was used as a target. Using a PEM apparatus, O₂ was added as a reaction gas in a ratio to give Al₂O₃, and 1000 W was given to the target for plasma discharge, whereby the target was sputtered. A 30-nm film was formed, and this is a sample (A-1). (Production of Sample A-2)

In an earthed vacuum chamber, Ar was used as a discharge gas, a PES film was used as a support, and Al was used as a target. Using a PEM apparatus, O₂ was added as a reaction gas in a ratio to give Al₂O₃, and 1000 W was given to the target for plasma discharge, whereby the target was sputtered. A 30-nm film was formed, and this is a sample (A-2).

### (Production of Sample A-3)

In a vacuum chamber, a PEN film was used as a support, and MMA and Irgacure 907 were co-deposited through vapor deposition to a thickness of 500 nm under temperature control to be a ratio of 100/1, and then polymerized by UV irradiation. Next, the support was transported into an earthed vacuum chamber, in which Ar was used as a discharge gas, and Al was used as a target. Using a PEM apparatus, O₂ was added as a reaction gas in a ratio to give Al₂O₃, and 1000 W was given to the target for plasma discharge, whereby the target was sputtered. A 30-nm film was formed, and this is a sample (A-3).

### (Production of Sample A-4)

In an earthed vacuum chamber, Ar was used as a discharge gas, a PEN film was used as a support, and as a target, a 100-µm PMMA film was stuck to the copper-made backing plate. An RF power of 200 W was given to the target, and at 0°C and 1 Pa, the target was sputtered by plasma discharge. After a 500-nm film was formed, the target was changed to Al. Using a PEM apparatus, O₂ was added as a reaction gas in a ratio to give Al₂O₃, and 1000 W was given to the target for plasma discharge, whereby the target was sputtered. A 30-nm film was formed, and this is a sample (A-4).

### (Production of Sample A-5)

In an earthed vacuum chamber, Ar was used as a discharge gas, a PEN film was used as a support, and as a target, a 100-µm PMMA film was stuck to the copper-made backing plate. An RF power of 200 W was given to the target, and an RF power of 10 W was to the support, and at 0°C and 1 Pa, the target was sputtered by plasma discharge. After a 500-nm film was formed, the target was changed to Al. Using a PEM apparatus, O₂ was added as a reaction gas in a ratio to give Al₂O₃, and 1000 W was given to the target for plasma discharge, whereby the target was sputtered. A 30-nm film was formed, and this is a sample (A-5). (Production of Sample A-6)

In an earthed vacuum chamber, Ar was used as a discharge gas, a PEN film was used as a support, and as a target, a 100-µm PEN film was stuck to the copper-made backing plate. An RF power of 200 W was given to the target, and at 0°C and 1 Pa, the target was sputtered by plasma discharge. After a 500-nm film was formed, the target was changed to Al. Using a PEM apparatus, O₂ was added as a reaction gas in a ratio to give Al₂O₃, and' 1000 W was given to the target for plasma discharge, whereby the target was sputtered. A 30-nm film was formed, and this is a sample (A-6).

### (Production of Sample A-7)

In an earthed vacuum chamber, Ar was used as a discharge gas, a PEN film was used as a support, and as a target, a 100-µm PEN film was stuck to the copper-made backing plate. An RF power of 200 W was given to the target, and an RF power of 10 W was given to the support, and at 0°C and 1 Pa, the target was sputtered by plasma discharge. After a 500-nm film was formed, the target was changed to Al. Using a PEM apparatus, O₂ was added as a reaction gas in a ratio to give Al₂O₃, and 1000 W was given to the target for plasma discharge, whereby the target was sputtered. A 30-nm film was formed, and this is a sample (A-7).

### (Production of Sample A-8)

In an earthed vacuum chamber, Ar was used as a discharge gas, a PEN film was used as a support, and as a target, a 100-µm PES film was stuck to the copper-made backing plate. An RF power of 200 W was given to the target, and at 0°C and 1 Pa, the target was sputtered by plasma discharge. After a 500-nm film was formed, the target was changed to Al. Using a PEM apparatus, O₂ was added as a reaction gas in a ratio to give Al₂O₃, and 1000 W was given to the target for plasma discharge, whereby the target was sputtered. A 30-nm film was formed, and this is a sample (A-8).

### (Production of Sample A-9)

In an earthed vacuum chamber, Ar was used as a discharge gas, a PEN film was used as a support, and as a target, a 100-µm PES film was stuck to the copper-made backing plate. An RF power of 200 W was given to the target, and an RF power of 10 W was given to the support, and at 0°C and 1 Pa, the target was sputtered by plasma discharge. After a 500-nm film was formed, the target was changed to Al. Using a PEM apparatus, O₂ was added as a reaction gas in a ratio to give Al₂O₃, and 1000 W was given to the target for plasma discharge, whereby the target was sputtered. A 30-nm film was formed, and this is a sample (A-9).

### (Determination of Water Vapor Permeability)

According to the method described in G. NISATO, P. C. P. BOUTEN, P. J. SLIKKERVEER, et al's SID Conference Record of the International Display Research Conference, pp. 1435-1438, the water vapor permeability at 40°C and at a relative humidity of 90% of the barrier laminates (A-1) to (A-9) was measured. The results are shown in Table 1.

### [Example 2]

Production and Evaluation of Barrier Laminate by Sputtering:

### (Production of Sample B-1)

In an earthed vacuum chamber, Ar was used as a discharge gas, a PEN film was used as a support, and as a target, a PMMA film having a thickness of 100 µm was stuck to the copper-made backing plate. An RF power of 200 W was given to the target, and an RF power of 10 W was to the support, and at 0°C and 1 Pa, the target was sputtered by plasma discharge. After a 500-nm film was formed, the target was changed to Si. Using a PEM apparatus, N₂ was added as a reaction gas in a ratio to give Si₃N₄, and 1000 W was given to the target for plasma discharge, whereby the target was sputtered. A 30-nm film was formed, and this is a sample (B-1).

### (Production of Sample B-2)

In an earthed vacuum chamber, Ar was used as a discharge gas, a PEN film was used as a support, and as a target, a PEN film having a thickness of 100 µm was stuck to the copper-made backing plate. An RF power of 200 W was given to the target, and an RF power of 10 W was to the support, and at 0°C and 1 Pa, the target was sputtered by plasma discharge. After a 500-nm film was formed, the target was changed to Si. Using a PEM apparatus, N₂ was added as a reaction gas in a ratio to give Si₃N₄, and 1000 W was given to the target for plasma discharge, whereby the target was sputtered. A 30-nm film was formed, and this is a sample (B-2).

### (Production of Sample B-3)

In an earthed vacuum chamber, Ar was used as a discharge gas, a PEN film was used as a support, and as a target, a PES film having a thickness of 100 µm was stuck to the copper-made backing plate. An RF power of 200 W was given to the target, and an RF power of 10 W was to the support, and at 0°C and 1 Pa, the target was sputtered by plasma discharge. After a 500-nm film was formed, the target was changed to Si. Using a PEM apparatus, N₂ was added as a reaction gas in a ratio to give Si₃N₄, and 1000 W was given to the target for plasma discharge, whereby the target was sputtered. A 30-nm film was formed, and this is a sample (B-3).

### (Determination of Water Vapor Permeability)

According to the method described in G. NISATO, P. C. P. BOUTEN, P. J. SLIKKERVEER, et al' s SID Conference Record of the International Display Research Conference, pp. 1435-1438, the water vapor permeability at 40°C and at a relative humidity of 90% of the barrier laminates (B-1) to (B-3) was measured. The results are shown in Table 1.

### [Example 3]

Production and Evaluation of Barrier Laminate by CVD:

### (Production of Sample C-1)

In an earthed vacuum chamber, Ar was used as a discharge gas, a PEN film was used as a support, and as a target, a PMMA film having a thickness of 100 µm was stuck to the copper-made backing plate. An RF power of 200 W was given to the target, and an RF power of 10 W was to the support, and at 0°C and 1 Pa, the target was sputtered by plasma discharge. After a 500-nm film was formed, the organic layer-having support was, while protected from exposure to air, transferred into a CVD chamber in vacuum. In the CVD chamber, silane gas (SiH₄), ammonia gas (NH₃) and nitrogen gas (N₂) were introduced. An RF discharge powder at a frequency of 13.56 MHz was given to form a film at a temperature of 25°C and under a film formation pressure of 10 Pa. A 100-nm film was formed, and this is a sample (C-1).

### (Production of Sample C-2)

In an earthed vacuum chamber, Ar was used as a discharge gas, a PEN film was used as a support, and as a target, a PEN film having a thickness of 100 µm was stuck to the copper-made backing plate. An RF power of 200 W was given to the target, and an RF power of 10 W was to the support, and at 0°C and 1 Pa, the target was sputtered by plasma discharge. After a 500-nm film was formed, the organic layer-having support was, while protected from exposure to air, transferred into a CVD chamber in vacuum. In the CVD chamber, silane gas (SiH₄), ammonia gas (NH₃) and nitrogen gas (N₂) were introduced. An RF discharge powder at a frequency of 13.56 MHz was given to form a film at a temperature of 25°C and under a film formation pressure of 10 Pa. A 100-nm filmwas formed, and this is a sample (C-2).

### (Production of Sample C-3)

In an earthed vacuum chamber, Ar was used as a discharge gas, a PEN film was used as a support, and as a target, a PES film having a thickness of 100 µm was stuck to the copper-made backing plate. An RF power of 200 W was given to the target, and an RF power of 10 W was to the support, and at 0°C and 1 Pa, the target was sputtered by plasma discharge. After a 500-nm film was formed, the organic layer-having support was, while protected from exposure to air, transferred into a CVD chamber in vacuum. In the CVD chamber, silane gas (SiH₄), ammonia gas (NH₃) and nitrogen gas (N₂) were introduced. An RF discharge powder at a frequency of 13.56 MHz was given to form a film at a temperature of 25°C and under a film formation pressure of 10 Pa. A 100-nm film was formed, and this is a sample (C-3).

### (Determination of Water Vapor Permeability)

According to the method described in G. NISATO, P. C. P. BOUTEN, P. J. SLIKKERVEER, et al' s SID Conference Record of the International Display Research Conference, pp. 1435-1438, the water vapor permeability at 40°C and at a relative humidity of 90% of the barrier laminates (C-1) to (C-3) was measured. The results are shown in Table 1.

**Table 1**

| Sample No. | Substrate | Organic Layer | Method of Organic Layer Formation | Substrate Bias | Inorganic Layer | Method of Inorganic Layer Formation | Water Vapor Permeability (g/m²/day) | Remarks |
|---|---|---|---|---|---|---|---|---|
| A-1 | PEN | - | - | no | Al₂O₃ | sputtering | 1.3 | comparative |
| A-2 | PES | - | - | no | Al₂O₃ | sputtering | 3.7 | comparative |
| A-3 | PEN | PMMA | vapor deposition polymerization | no | Al₂O₃ | sputtering | 0.17 | comparative example |
| A-4 | PEN | PMMA | sputtering | no | Al₂O₃ | sputtering | 0.035 | the invention |
| A-5 | PEN | PMMA | sputtering | yes | Al₂O₃ | sputtering | 0.009 | the invention |
| A-6 | PEN | PEN | sputtering | no | Al₂O₃ | sputtering | 0.025 | the invention |
| A-7 | PEN | PEN | sputtering | yes | Al₂O₃ | sputtering | 0.005 | the invention |
| A-8 | PEN | PES | sputtering | no | Al₂O₃ | sputtering | 0.013 | the invention |
| A-9 | PEN | PES | sputtering | yes | Al₂O₃ | sputtering | 0.003 | the invention |
| B-1 | PEN | PMMA | sputtering | yes | Si₃N₄ | sputtering | 0.017 | the invention |
| B-2 | PEN | PEN | sputtering | yes | Si₃N₄ | sputtering | 0.010 | the invention |
| B-3 | PEN | PES | sputtering | yes | Si₃N₄ | sputtering | 0.009 | the invention |
| C-1 | PEN | PMMA | sputtering | yes | Si₃N₄ | CVD | 0.019 | the invention |
| C-2 | PEN | PEN | sputtering | yes | Si₃N₄ | CVD | 0.012 | the invention |
| C-3 | PEN | PES | sputtering | yes | Si₃N₄ | CVD | 0.009 | the invention |

| | | | | | | | | |
|---|---|---|---|---|---|---|---|---|
| (Note) PEN: polyethylene terephthalate, PES: polyether sulfone, PMMA: polymethyl methacrylate | | | | | | | | |

The samples (A-6), (A-7), (A-8) and (A-9) confirm that even an organic material which has heretofore been difficult to form into a thin film can be formed into an organic layer film according to the invention. Comparing the samples (A-1) and (A-2) with the samples (A-3) to (A-9) confirms that, when an inorganic layer is formed directly on a support, then the water vapor permeability of the structure is high, but when an organic layer is first formed on an support and then an inorganic layer is formed thereon, then the water vapor permeability of the structure may be lowered. This is because the support may be scratched or may have dust adhering thereto, and an inorganic thin film could not cover it; and when the an organic layer not scratched or not having dust adhering thereto is first formed on the support, then the water vapor permeability of the laminate structure may be lowered to at most 0.1 g/m²/day. Comparing the sample (A-3) with the samples (A-4) and (A-5) confirms that the laminate, in which the organic layer was formed according to a sputtering method but not a vapor deposition method for conventional one-through vacuum film formation method, may have a lowered water vapor permeability. Comparing the samples (A-4), (A-6) and (A-8) with the samples (A-5), (A-7) and (A-9) confirms that bias application to the support further lowers the water vapor permeability of the laminate structure. This may be because the organic layer is crosslinked by plasma to be a stiff and tough layer resistant to exposure to plasma, and therefore a denser inorganic layer could be formed on the tough organic layer. It has been confirmed that, as the organic layer, PES is the best as most effective for lowering the water vapor permeability of the laminate structure. The samples (B-1) to (B-3) and the samples (C-1) to (C-3) confirm that the invention is also effective for the Si₃N₄ film formed according to a sputtering method or a CVD method.

### [Example 4]

### Production and Evaluation of Barrier Laminate:

Barrier laminates were produced and evaluated in the same manner as in Example 1, for which, however, a polyethylene terephthalate (PET having a thickness of 100 µm; Toray's Lumirror T60) film was used as the support. As a result, they had almost the same data as in Table 1.

### [Example 5]

### Production and Evaluation of Organic EL Device:

### (Production of Organic EL Device)

An ITO film-coated conductive glass substrate (surface resistivity, 10 Ω/square) was washed with 2-propanol, and then subjected to UV-ozone treatment for 10 minutes. On this substrate (anode), the following organic compound layers were deposited in order according to a vapor deposition method.

First Hole Transportation Layer:
Copper Phthalocyanine thickness 10 nm

Second Hole Transportation Layer:
N,N'-diphenyl-N,N'-dinaphthylbenzidine thickness 40 nm
   Light Emission Layer serving also as electron transportation layer: Tris(8-hydroxyquinolinato)aluminum thickness 60 nm
   Finally, lithium fluoride was vapor-deposited in a thickness of 1 nm and metal aluminum was in a thickness of 100 nm in that order, serving as a cathode. On this, a silicon nitride film having a thickness of 3 µm was formed according to a parallel plate CVD method, thereby constructing an organic EL device.

### (Disposition of Gas-Barrier Laminate on Organic EL Device)

Using a thermosetting adhesive (Daizo-Nichimori's Epotec 310), the barrier laminate of samples (A-4) to (A-9) produced in Example 1 and the above organic EL device substrate were stuck together in such a manner that the inorganic layer of the laminate could be on the side of the organic EL device substrate, and heated at 65°C for 3 hours to cure the adhesive. In that manner, sealed organic EL devices were produced. 20 sealed samples were produced per one barrier laminate.

### (Evaluation of Light-Emitting Surface of Organic EL Device)

Immediately after their production, the organic EL devices were driven for light emission at a voltage of 7V applied thereto, using a source measure unit (Keithley's SMU2400 Model). Using a microscope, the surface of each sample was checked for its condition with light emission, and it was confirmed that all the devices gave uniform light emission with no dark spot.

Next, the devices were kept in a dark room at 60°C and a relative humidity of 90% for 24 hours, and checked for the surface condition with light emission. The proportion of the samples with dark spots having a diameter of larger than 300 µm is defined as a failure ratio; and the failure ratio of each sample was determined. As a result, it was confirmed that the failure ratio of the organic EL devices produced by the use of the barrier laminate of samples (A-4) to (A-9) was zero, and all the devices gave good and uniform light emission.

### [Example 6]

### Production and Evaluation of Organic EL Device:

Sealed organic EL devices were produced in the same manner as in Example 5, for which, however, the barrier laminates of Samples (A-4) to (A-9) produced in Example 1 were used. In disposing the gas-barrier laminate on the organic EL device, a UV-curable adhesive (Nagase Ciba's XNR5516HV) was used in place of the thermosetting adhesive, and the adhesive was cured for adhesion through UV irradiation in an argon gas-purged globe box. The samples were evaluated in the same manner as in Example 5, and their data were almost the same as in Example 1.

### [Example 7]

Production of Organic EL Device, using barrier laminate as substrate:
The barrier laminate of samples (A-4) to (A-9) produced in Example 1 was introduced into a vacuum chamber; and using an ITO target, a transparent electrode of a thin ITO film having a thickness of 0.2 µm was formed thereon according to DC magnetron sputtering. The ITO film-having barrier laminate was put into a washing tank, ultrasonically washed therein with 2-propanol, and then processed for UV-ozone treatment for 30 minutes . Using the substrate, an organic EL device was produced in the same manner as in Example 5. In the device, both the substrate and the sealing film comprise a resin as the main ingredient, and the device was therefore flexible.

## Claims

1. A method for producing a barrier laminate having at least one organic layer and at least one inorganic layer on a support, which comprises forming the organic layer by sputtering.

2. The method for producing a barrier laminate according to Claim 1, wherein the organic layer is formed with applying a bias current to the support.

3. The method for producing a barrier laminate according to Claim 1 or 2, wherein the organic layer comprises a polyether sulfone as a main ingredient thereof.

4. The method for pcing a barrier laminate according to any one of Claims 1 to 3, wherein the support is a plastic film.

5. The method for producing a barrier laminate according to any one of Claims 1 to 3, wherein the support is an organic EL substrate.

6. The method for producing a barrier laminate according to any one of Claims 1 to 5, which further comprises forming the inorganic layer by sputtering.

7. The method for producing a barrier laminate according to Claim 6, wherein the inorganic layer comprises aluminum oxide or silicon nitride.

8. The method for producing a barrier laminate according to any one of Claims 1 to 5, wherein the inorganic layer is formed by CVD.

9. The method for producing a barrier laminate according to Claim 8, wherein the inorganic layer comprises silicon nitride.

10. The method for producing a barrier laminate according to Claim 7, wherein the organic layer and the inorganic layer are formed in the same sputtering apparatus.

11. The method for producing a barrier laminate according to any one of Claims 6 to 9, wherein the organic layer and the inorganic layer are formed in order while kept in a vacuum.

12. A barrier laminate satisfying at least one of the following conditions:
(1) the barrier laminate produced by the method of any one of Claims 1 to 11,
(2) the barrier laminate having at least one organic layer and at least one inorganic layer on a support, wherein the organic layer is a layer formed by using a target of an organic material having a molecular weight of at least 2000 as a main ingredient, and the barrier laminate has a water vapor permeability of less than 0.1 g/m²/day, and
(3) the barrier laminate having at least one organic layer and at least one inorganic layer on a support, wherein the organic layer is a layer comprising a polyethylene naphthalate or a polyether sulfone as a main ingredient, and the barrier laminate has a water vapor permeability of less than 0.1 g/m²/day.

13. The barrier laminate according to Claim 12, which satisfies (1).

14. The barrier laminate according to Claim 12 or 13, which satisfies (2).

15. The barrier laminate according to any one of Claims 12 to 14, which satisfies (3).

16. A device comprising the barrier laminate of any one of Claims 12 to 15.

17. The device according to Claim 16, wherein the barrier laminate is used as a sealant film.

18. The device according to Claim 16 or 17, which is an organic EL device.

19. An optical component comprising the barrier laminate of any one of Claims 12 to 15.
